# EUROPÄISCHE PATENTANMELDUNG

(11) **EP 1 760 480 A1**
(43) Veröffentlichungstag der Anmeldung: **07.03.2007**
(21) Anmeldenummer: 06017951.2
(22) Anmeldetag: 29.08.2006
(51) Int. Cl.: G01R 33/3815, G01R 33/31

(54) **NMR-Apparatur mit gemeinsam gekühltem Probenkopf und Kryobehälter**

(30) Priorität: 01.09.2005 DE 102005041383
(71) Anmelder: Bruker BioSpin AG, 8117 Fällanden (CH)
(72) Erfinder: Bösel, Johannes, 6345 Neuheim (CH); Glémot, Agnes, 8006 Zürich (CH); Eckert, Daniel, 8184 Bachenbülach (CH); Baumann, Daniel Guy, 8332 Russikon (CH)
(74) Vertreter: Kohler Schmid Möbus

(57) **Zusammenfassung**

Eine NMR-Apparatur mit einem in einem ersten Kryobehälter (2) eines Kryostaten (9) angeordneten NMR-Magnetsystem und mit einem NMR-Probenkopf (1), wobei der erste Kryobehälter (2) in einem evakuierten Außenmantel eingebaut ist und von einem Strahlungsschild (24) und/oder einem weiteren Kryobehälter (3) umgeben ist, wobei zur Kühlung des NMR-Probenkopfs (1) und eines Kryobehälters (2, 3) eine Kühlvorrichtung vorgesehen ist, welche einen Kaltkopf (4, 4a, 4b, 4c) mit mehreren Kältestufen (12a, 12b, 12c, 18a, 18b, 18c, 19a) umfasst, wobei eine Kältestufe (12a, 12b, 12c, 18a, 18b, 18c, 19a) mit einer Wärme übertragenden Vorrichtung verbunden ist, und wobei ein Kühlkreislauf zwischen der Kühlvorrichtung und dem NMR-Probenkopf (1) vorgesehen ist, ist dadurch gekennzeichnet, dass die Kühlvorrichtung in einem separaten, evakuierten Gehäuse (6) angeordnet ist, welches unmittelbar oberhalb des Kryostaten (9) positioniert ist, wobei die Wärme übertragende Vorrichtung unmittelbar in Aufhängerohre (29a, 29c) des Kryobehälters (2, 3) eingeführt und/oder mit dem Strahlungsschild (24) kontaktiert ist. Hierdurch wird ein einfacher Aufbau realisiert und eine effiziente Kühlung einer NMR-Apparatur ermöglicht.

## Beschreibung

Die Erfindung betrifft eine NMR-Apparatur mit einem in einem ersten Kryobehälter eines Kryostaten angeordneten NMR-Magnetsystem und mit einem in einer Raumtemperaturbohrung des Kryostaten angeordneten NMR-Probenkopf, der einen HF-Resonator zum Empfang von NMR-Signalen aus einer zu untersuchenden Probe und einen Vorverstärker umfasst, wobei der erste Kryobehälter in einem evakuierten Außenmantel eingebaut ist und von mindestens einem Strahlungsschild und/oder einem weiteren Kryobehälter umgeben ist, wobei zur Kühlung des NMR-Probenkopfs und mindestens eines Kryobehälters eine Kühlvorrichtung vorgesehen ist, welche einen kompressorbetriebenen Kaltkopf eines Kryokühlers mit mehreren Kältestufen auf unterschiedlichen Temperaturniveaus umfasst, wobei mindestens eine Kältestufe des Kaltkopfes mit einer Wärme übertragenden Vorrichtung thermisch leitend verbunden ist, und wobei mindestens ein über eine zumindest teilweise wärmeisolierte Transferleitung durch den Kompressor des Kryokühlers oder eine Pumpe angetriebener Kühlkreislauf mit einem Kälteträger zwischen der Kühlvorrichtung und dem NMR-Probenkopf vorgesehen ist.

Eine derartige Vorrichtung ist aus WO 03/023433 und EP 1 560 035 bekannt.

NMR-Apparaturen werden zur Bildgebung (Imaging) oder Spektroskopie (Spectroscopy) verwendet. Sie enthalten üblicherweise supraleitende Magnete, die auf sehr tiefe Temperaturen abgekühlt werden müssen.

NMR-Magnetsysteme werden heute noch meistens mit flüssigen Kryogenen (LN₂, LHe) gekühlt. Jedoch ist die Handhabung der Kryogene nicht ganz einfach. Ferner müssen diese in bestimmten Zeitabständen nachgefüllt werden, woraus oft ein unerwünschter Unterbruch der Messungen entsteht. Die Abhängigkeit von flüssigen Kryogenen ist zudem dort problematisch, wo keine optimale Infrastruktur hierfür vorhanden ist, wie z.B. in Schwellenländern (Indien, China, etc.). Auch eine zukünftige Verteuerung der Kryogene könnte eine solche Kühlung recht kostspielig machen.

Daher ist man schon seit einiger Zeit bemüht, die Magnetsysteme direkt oder indirekt mit mechanischen Kühlapparaten, sog. Kryokühlern, zu kühlen. Als besonders aussichtsreich hat sich das Konzept erwiesen, im Inneren der Kryostate zwar immer noch ein oder zwei flüssige Kryogene zuzulassen, diese aber mit Hilfe des Kryokühlers nach dem Verdampfen (aufgrund von Wärmeeintrag von außen) wieder zu verflüssigen, so dass nach außen kryogenverlustfreie Magnetsysteme entstehen. Hierzu gibt es mehrere Varianten, wie z.B. den Einbau des Kaltkopfs des Kryokühlers direkt in den Kryostaten, einmal im vakuumisolierten Bereich des Außenmantels des Kryostaten, ein andermal in einem Halsrohr unter HeliumAtmosphäre, welches den Helium-Behälter direkt mit dem Außenmantel verbindet.

Auch die Kühlung des HF-Resonators und Vorverstärkers eines NMR-Probenkopfs ist seit einiger Zeit üblich. Auf diese Weise wird das Signal-zu-RauschVerhältnis, also die Auflösung des NMR-Signals, verbessert und schnellere Messungen werden ermöglicht. Dieser sog. NMR-Probenkopf wird über einen Gaskältekreislauf, der mit einem Kryokühler verbunden ist, gekühlt. Der Kaltkopf des Kryokühlers und die verschiedenen Komponenten des Gaskältekreislaufs, wie Wärmetauscher und Ventile, befinden sich in einem separaten wärmeisolierten Gehäuse, das neben dem Magnetkryostaten zu stehen kommt. Der Kryokühler wird von einem Kompressor angetrieben, der üblicherweise eine Anschlussleistung im Bereich von etwa 7 kW hat. Die Kühlung des HF-Resonators und Vorverstärkers eines NMR-Probenkopfs wurde in US 5,889,456 beschrieben.

Möchte ein Anwender ein kryogenverlustfreies Magnetsystem mit einem NMR-Probenkopf kombinieren, so muss er zwei Kühlsysteme mit großem Platzbedarf und hohen Anschaffungs- und Betriebskosten und weiteren Nachteilen in Kauf nehmen.

In WO 03/023433 (*Oxford Instruments Superconductivity*) wurde daher eine kombinierte Kühlung von einem Magnetsystem und einem Probenkopf mit nur einem Kühler veröffentlicht. Darin wird vorgeschlagen, einen einzigen Kryokühler (Gifford-McMahon- oder Pulsrohr-Kühler) sowohl zur Kühlung des (Magnet-) Kryostaten als auch zur Kühlung eines mehr oder weniger fest montierten Probenkopfs zu verwenden. Der Kaltkopf des Kühlers ist dabei im Kryostaten integriert. Die erste Kältestufe des Kaltkopfs ist mit einem Strahlungsschild des Kryostaten kontaktiert, während die zweite Kältestufe direkt verdampfendes Helium verflüssigt. Ein separater Helium-Gaskreislauf, angetrieben über eine Pumpe, wird über die Kältestufen geführt, wo sich das Gas abkühlt und verflüssigt, um anschließend über eine Leitung, vorzugsweise im Inneren des Kryostaten oder in einem eigenen, evakuierbaren Gehäuse, zum Probenkopf (mit Gradienten-Spulen und HF-Resonator in einem eigenen, evakuierbaren Gehäuse) und den Shim-Spulen (im Kryostaten oder dem evakuierbaren Gehäuse der HF-Einheit) geführt zu werden.

Diese Anordnung ist jedoch relativ aufwendig und ermöglicht, da die Komponenten (Gasleitungen, Probenkopf) teilweise fest montiert sind, keinen flexiblen Betrieb. Durch die langen Transferleitungen, den Wärmeeintrag über die Umwälzpumpe und die Kontaktierung des Kühlkreises mit dem Strahlungsschild bei sehr tiefen Temperaturen weist die bekannte Anordnung nur eine geringe thermodynamische Effizienz auf. Fraglich ist auch, ob die mit heutigen Kryokühlern möglichen Kälteleistungen ausreichen, um Kryostat und Probenkopf in der angegebenen Weise zu kühlen. Ein weiteres Problem stellt die Tatsache dar, dass die Vibrationsentkopplung zwischen dem Kühler und dem Magneten nur unzureichend ausgebildet ist, so dass das Magnetfeld des Magnetsystems vom Kryokühler beeinflusst werden kann. Darüber hinaus können bei dieser Apparatur während Wartungsarbeiten am Kühlsystem keine NMR-Messungen durchgeführt werden.

Einige der Nachteile aus WO 03/023433 werden in EP 1 560 035 *(Oxford Instruments Superconductivity*) vermieden. So ist z.B. die dort vorgeschlagene Kühlvorrichtung thermodynamisch effizienter. Nach wie vor bestehen jedoch auch hier gravierende Nachteile: Der Kaltkopf des Kryokühlers wird fest in den Kryostaten eingebaut, so dass sowohl Vibrationen als auch elektromagnetische Störungen des Kaltkopfes mehr oder weniger ungehindert auf den Magnetkryostaten übertragen werden. Umgekehrt ist eine Beeinflussung des Kryokühlers über den supraleitenden Magneten im Magnetkryostaten möglich. Die Wartung bzw. der Austausch des Kaltkopfes ist nach wie vor mit erheblichem Aufwand und Kosten verbunden, da dann das gesamte Magnetsystem außer Betrieb genommen werden muss. Weiter lassen sich auch bestehende, konventionelle Magnetsysteme nicht einfach nachrüsten, sondern es ist eine komplette Neukonstruktion nötig.

Aufgabe der vorliegenden Erfindung ist es, eine NMR-Apparatur vorzuschlagen, die die oben genannten Nachteile vermeidet und einen einfachen Aufbau aufweist.

Diese Aufgabe wird erfindungsgemäß dadurch gelöst, dass die Kühlvorrichtung in einem separaten, evakuierten und wärmeisolierten Gehäuse angeordnet ist, welches unmittelbar oberhalb des Kryostaten des NMR-Magnetsystems positioniert ist, und wobei mindestens eine der Wärme übertragenden Vorrichtungen direkt und unmittelbar in Aufhängerohre des ersten und/oder weiteren Kryobehälters des Kryostaten, durch welche die Kryobehälter mit dem Außenmantel verbunden sind, eingeführt und/oder mit dem Strahlungsschild kontaktiert ist.

Da das Gehäuse mit der Kühlvorrichtung außerhalb des Kryostaten angeordnet, und somit vom Kryostaten räumlich getrennt ist, treten gegenüber den aus WO 03/023433 und EP 1 560 035 bekannten Vorrichtungen weniger mechanische oder magnetische Störungen im Arbeitsvolumen, die von der Kühlvorrichtung stammen, auf.

Darüber hinaus erlaubt die externe Anordnung des Gehäuses ein nachträgliches Ausrüsten von konventionellen, bereits vorhandenen Systemen (Retrofit). Da der Kaltkopf nicht im Kryostaten untergebracht ist, können Wartungsarbeiten oder ein Service am Kühler vorgenommen werden, ohne den Betrieb des Kryostaten unterbrechen zu müssen.

Aufgrund der direkten Kühlung des Helium-Behälters ohne Transferleitungen oder externe Gaskreisläufe gibt es weniger Probleme mit Verunreinigungen, die z.B. zu Verstopfung von Leitungen führen können. Zusätzlich werden hierdurch die Kälteverluste durch Transferleitungen minimiert, so dass eine sehr effiziente Kühlung des Magnetsystems realisiert wird.

Die Kühlung von dem Magnetsystem und dem NMR-Probenkopf kann bei der erfindungsgemäßen NMR-Apparatur in zwei physisch getrennten, voneinander unabhängigen Mechanismen zur Kälteankopplung realisiert werden, so dass die Kühlung eines Kälteverbrauchers (Magnetsystem oder NMR-Probenkopf) unterbrochen werden kann, ohne dass die Kühlung des anderen Kälteverbrauchers beeinflusst wird.

Des Weiteren ist die erfindungsgemäße NMR-Apparatur kompakt, da die Kühlvorrichtung keinen Platz neben dem Kryostaten in Anspruch nimmt.

Die Kühlvorrichtung der erfindungsgemäßen NMR-Apparatur lässt sich auch bei anderen strukturauflösenden Methoden, wie z.B. der lonencyclotronresonanz-Spektroskopie (ICR) oder der Elektronenspinresonanz (ESR, EPR), vorteilhaft einsetzten.

Bei einer speziellen Ausführungsform der erfindungsgemäßen NMR-Apparatur ist das Gehäuse der Kühlvorrichtung am Kryostaten des NMR-Magnetsystems befestigt.

Eine alternative Ausführungsform sieht vor, dass das Gehäuse der Kühlvorrichtung extern, insbesondere an der Raumdecke oder einem Ständer, befestigt ist.

Für beide Ausführungsformen ist es vorteilhaft, wenn die Kühlvorrichtung über Bauteile, welche Schwingungen stark dämpfen oder nicht übertragen, insbesondere über Balgen, mit dem Kryostaten des NMR-Magnetsystems und dem Probenkopf gasdicht verbunden ist. Aufgrund der Ankopplung an den Kryostaten und den NMR-Probenkopf über ,weiche' Komponenten werden Vibrationen der Kühlvorrichtung nicht in den Kryostaten und den NMR-Probenkopf übertragen.

Eine vorteilhafte Ausführungsform der erfindungsgemäßen NMR-Apparatur sieht vor, dass zumindest eine der Wärme übertragenden Vorrichtungen eine metallische, die Wärme sehr gut leitende Verbindung aufweist, an deren Ende, welches in das Aufhängerohr des Kryobehälters hineinragt, ein Kryogen, das aus einem der Kryobehälter des Kryostaten verdampft, verflüssigt wird. Die Verflüssigung findet in diesem Fall direkt im Kryobehälter statt.

Besonders vorteilhaft ist es, wenn der Kryokühler ein Pulsrohrkühler oder ein Gifford-McMahon-Kühler mit mindestens zwei Kältestufen ist. Durch die effiziente Vibrations-Entkopplung lassen sich auch Kryokühler einsetzen, die von Natur aus stärkere Vibrationen, wie z.B. Gifford-McMahon-Kühler, aufweisen als die ohnehin schon vibrationsarmen Pulsrohrkühler, die bei anderen Lösungen zur Kryostatkühlung oft bevorzugt werden. Es ist jedoch auch denkbar, dass andere Kühler, wie Stirling- oder Joule-Thomson-Kühler zum Einsatz kommen.

Vorzugsweise weist zur Hinführung des aus einem der Kryobehälter des Kryostaten verdampften Kryogens zu der Kältestufe, und zur Rückführung des an der Kältestufe verflüssigten Kryogens in den Kryobehälter des Kryostaten, zumindest eine der Wärme übertragenden Vorrichtungen eine an beiden Enden offene Leitung, insbesondere eine Rohrleitung, und einen Hohlraum auf, wobei das eine offene Ende der Leitung in den Hohlraum und das andere offene Ende der Leitung in den Kryobehälter mündet. Das aus dem Kryobehälter verdampfte Kryogen gelangt somit über die Leitung in den Hohlraum, der mit einer Kältestufe des Kaltkopfes des Kryokühlers verbunden ist, wo es verflüssigt wird. Die Leitung kann aus einem oder aus mehreren konzentrischen Rohren bestehen, so dass der Kryogendampf in einem äußeren Ringspalt zum Hohlraum aufsteigt und das im Hohlraum verflüssigte Kryogen im Innenrohr in den Kryobehälter zurückfließt. Um eine möglichst gute Isolation gegenüber der Umgebung zu gewährleisten, kann die Leitung über eine Teillänge oder ihre gesamte Länge zusätzlich mit einer Vakuumisolierung versehen sein.

Bei einer besonders bevorzugten Ausführungsform der Erfindung weist zur Hinführung des aus dem weiteren Kryobehälter des Kryostaten verdampften und im Aufhängerohr auf etwa Umgebungstemperatur erwärmten Kryogens zu der Kältestufe, welche nicht die kälteste Kältestufe ist, und zur Rückführung des an der Kältestufe auf Verflüssigungstemperatur abgekühlten und verflüssigten Kryogens in den weiteren Kryobehälter, zumindest eine der Wärme übertragenden Vorrichtungen eine weitere, an beiden Enden offene Leitung, insbesondere eine Rohrleitung, mit guter thermischer Kontaktierung an der Kältestufe auf, die an einem offenen Ende mit dem warmen Ende des Aufhängerohres verbunden ist und deren anderes offenes Ende bis in den weiteren Kryobehälter reicht. Das abdampfende Kryogen erwärmt sich im Aufhängerohr, wodurch der Wärmeeintrag auf die Vorratsbehälter für das Kryogen reduziert wird. Es tritt als überhitzter Dampf (Gas) aus und wird durch die weitere Leitung abgeführt. Durch den Kontakt der weiteren Leitung mit dem Kaltkopf wird das Kryogen wieder abgekühlt und verflüssigt und dann in den Kryostaten zurückgeführt.

Ebenso ist es vorteilhaft, wenn zur Hinführung des aus dem ersten Kryobehälter des Kryostaten verdampften und im Aufhängerohr auf etwa Umgebungstemperatur erwärmten Kryogens zu der oder den Kältestufen des Kaltkopfs des Pulsrohrkühlers, welche wärmer als die kälteste Kältestufe sind, und zur Rückführung des Kryogens in den ersten Kryobehälter, die Wärme übertragende Vorrichtung eine weitere, an beiden Enden offene Leitung aufweist, insbesondere eine Rohrleitung, mit guter thermischer Kontaktierung an der oder den Kältestufen des Kaltkopfs des Pulsrohrkühlers und an zumindest dem kältesten Regeneratorrohr der Kältestufen des Kaltkopfs des Pulsrohrkühlers, wobei die weitere Leitung an einem der offenen Enden mit dem warmen Ende des Aufhängerohres verbunden ist und das andere offene Ende der weiteren Leitung bis in den ersten Kryobehälter reicht, so dass das Kryogen auf Verflüssigungstemperatur abgekühlt und verflüssigt wird. Durch diese Anordnung wird es möglich, dass auch ein tiefsiedendes Gas, wie z.B. Helium, thermodynamisch effizient abgekühlt und verflüssigt werden kann. Der zusätzliche Wärmeeintrag auf den Regenerator der kältesten Kältestufe beeinträchtigt die Kälteleistung des Kryokühlers nicht wesentlich, solange die abzukühlende und zu verflüssigende Menge an Gas nicht zu groß ist. Zudem wird die Gesamteffizienz der Apparatur gesteigert, da jetzt das Aufhängerohr des ersten Kryobehälters durch den am warmen Ende des Aufhängerohres abgeführten Kryogenstrom gekühlt wird, so dass der Wärmeeintrag über das Aufhängerohr idealerweise verschwindet.

Eine besonders bevorzugte Ausführungsform der erfindungsgemäßem NMR-Apparatur sieht vor, dass zumindest eine der Wärme übertragenden Vorrichtungen als geschlossener weiterer Kühlkreislauf mit einem weiteren Kälteträger zwischen mindestens einer Kältestufe des Kaltkopfs und mindestens einem der Kryobehälter und/oder dem Strahlungsschild ausgeführt ist, wobei als weiterer Kälteträger ein tiefsiedendes Gas vorgesehen ist, wobei der weitere Kühlkreislauf über Eigenkonvektion, eine Umwälzpumpe oder den Kompressor des Kryokühlers angetrieben wird. Wird der weitere Kühlkreislauf durch Eigenkonvektion angetrieben, ist keine zusätzliche Pumpe oder Zirkulation des Prozessgases durch den Kältekompressor notwendig.

Alternativ ist eine der Wärme übertragenden Vorrichtungen, die in den ersten Kryobehälter eingeführt ist, als Teilkreislauf des Kühlkreislaufs des NMR-Probenkopfs ausgeführt, wobei als Kälteträger ein tiefsiedendes Gas vorgesehen ist, und eine Vorrichtung zum Zwischenentspannen eines Teils des Kälteträgers vorgesehen, um einen anderen Teil des Kälteträgers vorzukühlen, wobei der Kühlkreislauf über den Kompressor des Kryokühlers und/oder einen weiteren Kompressor angetrieben wird. Die Entspannung eines Teilstroms des Kälteträgers in einer Drosselstelle kann bei einem realen Gas - abhängig vom Anfangs- und Endzustand - zu einer Abkühlung führen (positiver Joule-Thomson-Effekt). Durch geschickte Prozessführung ist es dann möglich, auch bei einer Temperatur, die unter der Temperatur der kältesten Kältestufe des Kaltkopfs liegt, Kälteleistung zur Kühlung des ersten Kryobehälters bereitzustellen. Unter Umständen wird dann jedoch ein zusätzlicher Kompressor notwendig, wenn der Kälteträger auf einen tieferen Druck als den vom Kältekompressor zur Verfügung gestellten Niederdruck entspannt wird.

Darüber hinaus kann zumindest eine der Wärme übertragenden Vorrichtungen, die in den weiteren Kryobehälter eingeführt oder mit dem Strahlungsschild kontaktiert ist, als Teilkreislauf des Kühlkreislaufs des NMR-Probenkopfs ausgeführt sein, wobei der Kreislauf über den Kompressor des Kryokühlers oder eine Umwälzpumpe angetrieben wird. Hierfür wird ein Teil des für die Kühlung des NMR-Probenkopfs verwendeten Kälteträgers bei einer geeigneten Temperatur vom Hauptstrom abgezweigt und in einer separaten Transferleitung zum weiteren Kryobehälter oder zum Strahlungsschild geführt. Das Gas nimmt dann über eine Wärme übertragende Vorrichtung die auf den weiteren Kryobehälter oder den Strahlungsschild einfallende Wärme auf. Bei Verwenden eines weiteren Kryobehälters treten somit geringere oder gar keine Verluste an Kryogen mehr auf, so dass ein Nachfüllen von Kryogen nicht oder nur sporadisch notwendig ist.

Bei der erfindungsgemäßen NMR-Apparatur ist vorzugsweise zumindest eine der Wärme übertragenden Vorrichtungen gegen Wärmeeinfall von außen isoliert, insbesondere mittels einer Vakuumisolierung. Auf diese Weise wird die Effizienz der NMR-Apparatur gesteigert.

Es ist von Vorteil, wenn die Wärme übertragende Vorrichtung zumindest abschnittsweise flexibel, insbesondere als Balg und/ oder in Form von zu Litzen verflochtenen Drähten, ausgeführt ist, so dass Vibrationen der Kühlvorrichtung auf den Magnetkryostaten oder den NMR-Probenkopf nicht oder nur abgeschwächt übertragen werden.

Vorzugsweise kann an der kältesten Kältestufe des Kaltkopfs des Kryokühlers flüssiges Helium bei einer Temperatur von 4,2 K oder bei tieferer Temperatur erzeugt werden. Dies ist insbesondere bei Verwendung eines Magnetsystems mit Tieftemperatursupraleitern notwendig.

An einer Kältestufe des Kaltkopfs des Kryokühlers sollte vorzugsweise flüssiger Stickstoff bei einer Temperatur von 77 K oder bei tieferer Temperatur erzeugt werden können. Somit lässt sich im Kryostaten des NMR-Magnetsystems ein weiterer Kryobehälter mit flüssigem Stickstoff verwenden oder ein Strahlungsschild auf eine thermodynamisch sinnvolle Temperatur kühlen.

Besonders vorteilhaft ist es, wenn im Kühlkreislauf zur Kühlung des NMR-Probenkopfs sich zumindest ein Teil des Kälteträgers in Wärmekontakt mit zumindest dem kältesten Regeneratorrohr der Kältestufen des Pulsrohrkühlers befindet, so dass der Kälteträger auf eine Temperatur im Bereich zwischen den Temperaturen der beiden kältesten Kältestufen abgekühlt wird. Auf diese Weise wird es möglich, Kälte bei einer Temperatur zwischen etwa 4,2 und 50 K zur Kühlung des NMR-Probenkopfs zur Verfügung zu stellen. Der zusätzliche Wärmeeintrag auf die Regeneratorrohre der Kältestufen beeinträchtigt die Kälteleistung des Pulsrohrkühlers, wobei jedoch die (thermodynamische) Gesamteffizienz der Apparatur steigt.

Eine besonders bevorzugte Ausführungsform der Erfindung sieht vor, dass eine Verbindungsleitung zwischen mindestens einem der Aufhängerohre des ersten Kryobehälters, in das keine die Wärme übertragende Vorrichtung eingeführt wird, und dem ersten Kryobehälter vorgesehen ist, wobei die Verbindungsleitung mit mindestens einer Kältestufe des Kaltkopfes des Kryokühlers der Kühlvorrichtung kontaktiert ist, wobei in der Verbindungsleitung ein Ventil und/oder eine Pumpe eingefügt werden kann. Bei Verwenden eines Pulsrohrkühlers kann die Verbindungsleitung auch mit dem Regeneratorrohr der kältesten Kältestufe verbunden sein. Somit wird der Wärmeeintrag über das Aufhängerohr, in das keine die Wärme übertragende Vorrichtung eingeführt wird, zumindest reduziert, da jetzt ein Kühlstrom durch das Aufhängerohr vorhanden ist. Die Gesamteffizienz der Apparatur steigt.

Bei einer speziellen Ausführungsform der erfindungsgemäßen NMR-Apparatur ist zur Kühlung des Vorverstärkers des NMR-Probenkopfs ein eigener, geschlossener Kühlkreislauf mit flüssigem und/oder dampfförmigen Stickstoff, innerhalb dessen der flüssige Stickstoff des Kühlkreislaufs verdampft und vom Kaltkopf der Kühlvorrichtung wieder verflüssigt wird, wobei der Kühlkreislauf über Eigenkonvektion oder eine Umwälzpumpe angetrieben wird, und eine Isolation gegen Wärmeeinfall von außen, insbesondere eine Vakuumisolierung, vorgesehen ist. Diese Variante weist unter Umständen thermodynamische Vorteile auf, so dass die Gesamteffizienz der Apparatur steigt.

Um eine übermäßige Verflüssigung von Kryogen und Absinken des Drucks im Kryobehälter, z.B. aufgrund von einer Überschussleistung des Kryokühlers, zu vermeiden, ist es vorteilhaft, wenn in mindestens einem der Kryobehälter eine elektrische Heizung vorgesehen ist.

Alternativ dazu kann auch an den Kältestufen des Kaltkopfs des Kryokühlers der Kühlvorrichtung oder an anderen Bestandteilen der Kühlvorrichtung, insbesondere an den Wärme übertragenden Vorrichtungen oder an den Leitungen, eine elektrische Heizung vorgesehen sein.

Besonders vorteilhaft ist es, wenn als Kälteträger des Kühlkreislaufs zwischen dem Kaltkopf des Kryokühlers und dem NMR-Probenkopf und/oder als weiterer Kälteträger des weiteren Kühlkreislaufs zwischen dem Kaltkopf des Kryokühlers und mindestens einem der Kryobehälter Helium dient. Helium wird bei Normaldruck erst bei 4,2 K flüssig und eignet sich daher auch als Kälteträger für Tiefsttemperaturanwendungen. Bei einem Druck oberhalb des kritischen Druckes (2.29 bar) findet kein Phasenwechsel mehr statt, so dass dann Helium als (quasieinphasiger) Kälteträger selbst unter 4,2 K eingesetzt werden kann.

Die Erfindung betrifft darüber hinaus ein Verfahren zum Betrieb einer NMR-Apparatur nach einem der vorhergehenden Ansprüche, wobei der NMR-Probenkopf sowie mindestens ein Kryobehälter der NMR-Apparatur mittels eines gemeinsamen Kryokühlers gekühlt werden. Das erfindungsgemäße Verfahren ist dadurch gekennzeichnet, dass die zur Kühlung des NMR-Probenkopfs und des Kryobehälters benötigte Temperatur und Kälteleistung außerhalb des Kryostaten erzeugt werden, wobei mindestens eine mit dem Kaltkopf des Kryokühlers kontaktierte Wärme übertragende Vorrichtung direkt und unmittelbar in Aufhängerohre des ersten und/oder weiteren Kryobehälters des Kryostaten eingeführt und/oder mit dem Strahlungsschild kontaktiert wird, wobei mit Hilfe der Wärme übertragenden Vorrichtung eine Verflüssigung des im Kryobehälter vorhandenen gasförmigen Kryogens stattfindet, und wobei über mindestens eine zumindest teilweise wärmeisolierte Transferleitung außerhalb des Kryostaten ein Kälteträger von der Kühlvorrichtung zu dem NMR-Probenkopf geleitet wird.

Eine Variante des erfindungsgemäßen Verfahrens sieht vor, dass die Verflüssigung des im Kryobehälter vorhandenen gasförmigen Kryogens am Ende einer in zumindest einen der Kryobehälter hineinragenden, metallischen, die Wärme sehr gut leitenden Verbindung erfolgt.

Darüber hinaus kann aus einem der Kryobehälter des Kryostaten verdampftes Kryogen durch eine Leitung, insbesondere eine Rohrleitung, in einen Hohlraum an der Kältestufe des Kaltkopfs des Kryokühlers geleitet, an der Kältestufe verflüssigt, und anschließend durch die Rohrleitung in den Kryobehälter des Kryostaten zurückgeleitet werden.

Bei einer weiteren vorteilhaften Variante wird aus einem der Kryobehälter des Kryostaten verdampftes Kryogen im Aufhängerohr des Kryobehälters auf etwa Umgebungstemperatur erwärmt, durch eine weitere Leitung und/oder die Verbindungsleitung, insbesondere eine Rohrleitung mit guter thermischer Kontaktierung an der Kältestufe, zu der Kältestufe hingeführt, dort und gegebenenfalls an zumindest dem kältesten Regeneratorrohr der des Kaltkopfs des Pulsrohrkühlers auf Verflüssigungstemperatur abgekühlt und schließlich verflüssigt, und als verflüssigtes Kryogen durch die weitere Leitung in den Kryobehälter rückgeführt.

Es kann auch vorteilhaft sein, wenn die Wärmeübertragung zwischen mindestens einer Kältestufe des Kaltkopfs und mindestens einem der Kryobehälter und/oder dem Strahlungsschild innerhalb eines geschlossenen Kühlkreislaufs mit einem weiteren Kälteträger erfolgt, wobei als weiterer Kälteträger ein tiefsiedendes Gas verwendet wird, wobei der Kühlkreislauf über Eigenkonvektion, eine Umwälzpumpe oder den Kompressor des Kryokühlers angetrieben wird.

Eine weitere vorteilhafte Variante des erfindungsgemäßen Verfahrens sieht vor, dass die Wärmeübertragung zwischen mindestens einer Kältestufe des Kaltkopfs und mindestens einem der Kryobehälter und/oder dem Strahlungsschild innerhalb eines Teilkreislaufs des Kühlkreislaufs des NMR-Probenkopfs erfolgt, wobei der Kreislauf über den Kompressor des Kryokühlers oder gegebenenfalls eine Umwälzpumpe angetrieben wird.

Dabei ist es von Vorteil, zur Kühlung des ersten Kryobehälters einen Teil des Kälteträgers durch Zwischenentspannung eines anderen Teils des Kälteträgers so vorzukühlen, dass durch Entspannung des vorgekühlten Teils des Kälteträgers auf den gleichen oder einen tieferen Gasdruck wie im ersten Kryobehälter der Kälteträger verflüssigt wird. Dies kann beispielsweise mittels eines oder mehrerer Joule-Thomson-Ventile und eines oder mehrerer Gegenstromtauscher erfolgen.

Es ist auch denkbar, dass der Vorverstärker des NMR-Probenkopfs mit flüssigem und/oder dampfförmigem Stickstoff in einem eigenen, geschlossenen Kreislauf gekühlt wird, wobei der flüssige Stickstoff bei Kontakt mit dem Vorverstärker des NMR-Probenkopfs während des Durchlaufens des Kreislaufs verdampft und vom Kaltkopf der Kühlvorrichtung wieder verflüssigt wird, wobei der Kreislauf über Eigenkonvektion oder eine Umwälzpumpe angetrieben wird.

Besonders vorteilhaft ist es, wenn als Kryokühler ein Pulsrohrkühler verwendet wird und wenn der zum Kühlen des NMR-Probenkopfs vorgesehene Kälteträger in Wärmekontakt mit zumindest dem kältesten Regeneratorrohr der Kältestufen des Kaltkopfes des Pulsrohrkühlers gebracht und somit auf eine Temperatur zwischen den Temperaturen der beiden kältesten Kältestufen abgekühlt wird.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine schematische Darstellung einer erfindungsgemäßen NMR-Apparatur mit einem Kryokühler zur gemeinsamen Kühlung eines Kryostaten sowie eines NMR-Probenkopfs;
- Fig. 2: einen schematischen Ausschnitt einer erfindungsgemäßen NMR-Apparatur mit einem dreistufigen Kryokühler und mit einer metallischen Wärme übertragenden Vorrichtung zur Kühlung eines ersten Kryobehälters und einer mit einem Hohlraum verbundenen Rohrleitung zur Kühlung eines weiteren Kryobehälters;
- Fig. 3: einen schematischen Ausschnitt einer erfindungsgemäßen NMR-Apparatur mit einem dreistufigen Kryokühler und mit einer mit einem Hohlraum verbundenen Rohrleitung zur Kühlung eines ersten Kryobehälters und einer weiteren Leitung zur Kühlung eines weiteren Kryobehälters;
- Fig. 4: einen schematischen Ausschnitt einer erfindungsgemäßen NMR-Apparatur mit einem dreistufigen Kryokühler und mit einer mit einem Hohlraum verbundenen Rohrleitung zur Kühlung eines ersten Kryobehälters und einer weiteren Leitung zur Kühlung eines Strahlungsschildes;
- Fig. 5: einen schematischen Ausschnitt einer erfindungsgemäßen NMR-Apparatur mit einem zweistufigen Kryokühler und mit einem gemeinsamen Kühlkreislauf zur Kühlung eines ersten Kryobehälters und eines NMR-Probenkopfs und mit einer mit einem Hohlraum verbundenen Rohrleitung zur Kühlung eines weiteren Kryobehälters;
- Fig. 6: einen schematischen Ausschnitt einer erfindungsgemäßen NMR-Apparatur mit einem dreistufigen Kryokühler und mit einer mit einem Hohlraum verbundenen Rohrleitung zur Kühlung eines ersten Kryobehälters und einem gemeinsamen Kühlkreislauf zur Kühlung eines Strahlungsschildes und eines NMR-Probenkopfs;
- Fig. 7: einen schematischen Ausschnitt einer erfindungsgemäßen NMR-Apparatur mit einem zweistufigen Pulsrohrkühler mit variablem Temperaturabgriff für einen Kühlkreislauf eines NMR-Probenkopfs und mit einer aus zwei Leitungen kombinierten Leitung zur Kühlung eines ersten Kryobehälters und mit einer weiteren Leitung zur Kühlung eines weiteren Kryobehälters; und
- Fig. 8: einen schematischen Ausschnitt einer erfindungsgemäßen NMR-Apparatur mit einem dreistufigen Kryokühler und mit einem separaten Kühlkreislauf für einen Vorverstärker eines NMR-Probenkopfs.

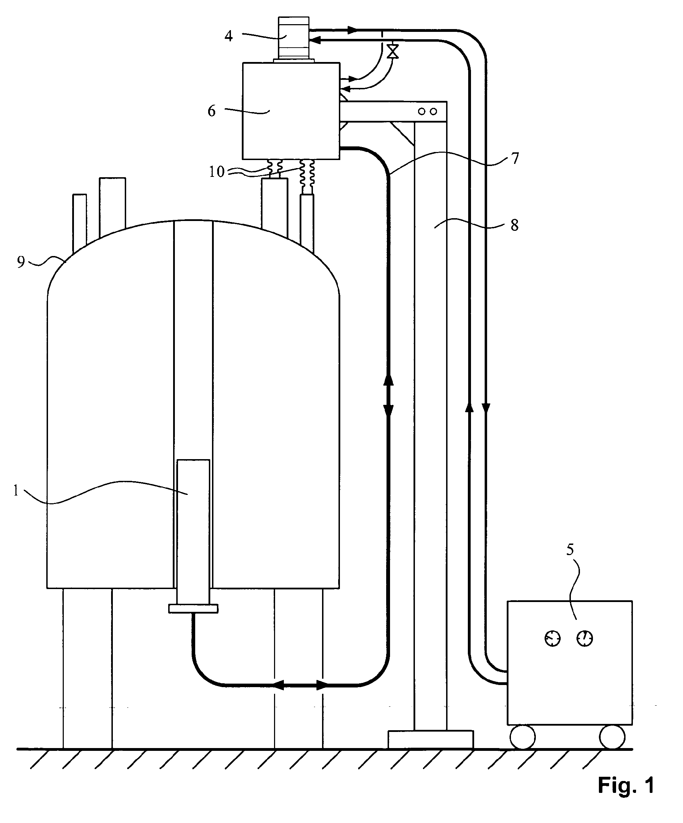

Die in **Fig. 1** gezeigte erfindungsgemäße NMR-Apparatur ermöglicht eine gleichzeitige Kühlung von einem NMR-Probenkopf **1** und eines Kryostaten **9**, mittels einer einzigen Kühlvorrichtung, welche kompakter und kostengünstiger ist als zwei separate Kühlvorrichtungen. Ein Kaltkopf **4** eines Kryokühlers, der durch einen Kompressor **5** betrieben wird, ist in einem externen, wärmeisolierten, evakuierten Gehäuse **6** untergebracht. Durch die externe Anordnung des Kryokühlers werden keine mechanischen oder magnetischen Störungen des Kryokühlers in das Arbeitsvolumen des NMR-Magnetsystems übertragen. Es besteht daher die Möglichkeit, sowohl vibrationsarme Pulsrohrkühler als auch Gifford-McMahon-Kühler, die größere Störungen verursachen, einzusetzen. Auch ist die Geometrie des Kaltkopfs 4 des Kryokühlers aufgrund der externen Anordnung keinen speziellen Einschränkungen unterworfen. Das Gehäuse 6 ist über eine oder mehrere Transferleitungen **7** mit dem NMR-Probenkopf 1 verbunden. Bei der in Fig. 1 gezeigten Ausführungsform ist das Gehäuse 6 an einem Ständer **8** befestigt und direkt oberhalb des Kryostaten 9 der NMR-Apparatur angeordnet. Um die Übertragung von Vibrationen vom Kaltkopf 4 zum Kryostaten 9 zu vermeiden, sind zwischen dem Gehäuse 6 und dem Kryostaten 9 Balgen **10** vorgesehen. Durch die gleichzeitige Kühlung des Kryostaten 9 und des NMR-Probenkopfs 1 mittels eines einzigen Kaltkopfs 4 kann die vorhandene Kälteleistung des Kryokühlers besonders effektiv genutzt und eine kompakte Kühleinheit realisiert werden.

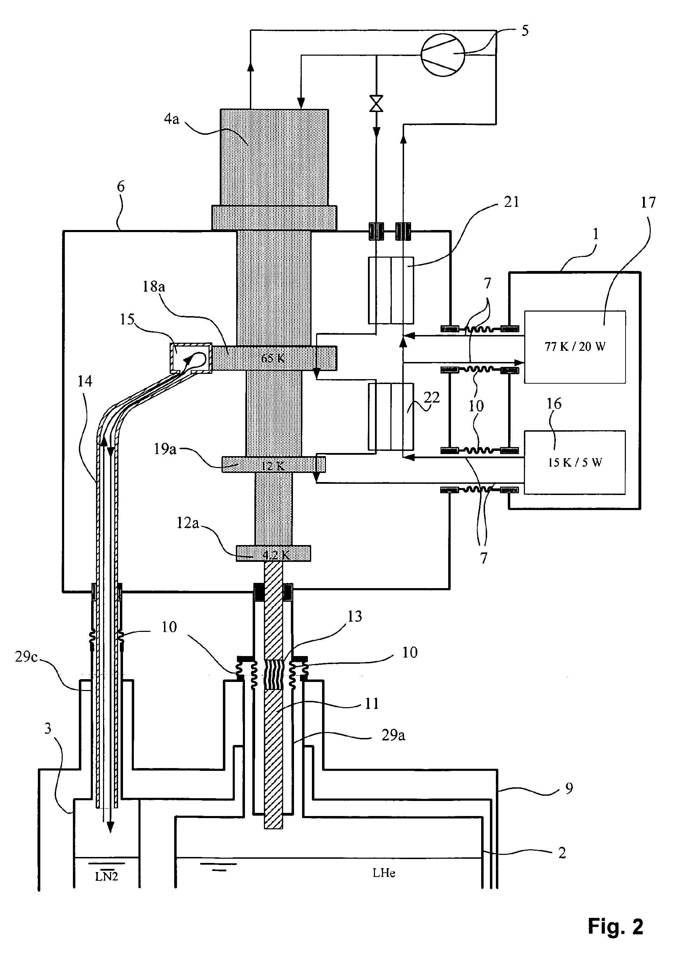

**Fig. 2** zeigt einen schematischen Ausschnitt einer erfindungsgemäßen NMR-Apparatur. Zur Kühlung eines ersten Kryobehälters **2** ist eine Wärme übertragende Vorrichtung in Form einer metallischen, die Wärme sehr gut leitenden Verbindung **11** (zum Beispiel aus Kupfer) vorgesehen, wobei die Verbindung 11 mit einem Ende mit der kältesten Kältestufe **12a** eines 3-stufigen Kaltkopfs **4a** verbunden ist und mit dem anderen Ende in den ersten Kryobehälter 2 hinein ragt. Die Verbindung 11 ist über ein Aufhängerohr **29a** des ersten Kryobehälters 2 in diesen eingeführt. Der im ersten Kryobehälter 2 vorhandene Kryogendampf wird an dem Ende der metallischen, die Wärme sehr gut leitenden Verbindung 11, welche in den ersten Kryobehälter 2 hinein ragt, verflüssigt, indem das Kryogen Wärme an die Verbindung 11 und somit an den Kaltkopf 4a abgibt. Um eine Übertragung von Vibrationen vom Kaltkopf 4a in den ersten Kryobehälter 2 über die Verbindung 11 zu vermeiden, ist die die Wärme gut leitende Verbindung 11 teilweise in Form von flexiblen Litzen **13** ausgeführt. Auf diese Weise wird eine weiche Verbindung realisiert. Vorzugsweise wird als Kryogen im ersten Kryobehälter 2 Helium verwendet, das bei einer Temperatur von ca. 4,2 K vorliegt.

Die Kühlung eines weiteren Kryobehälters **3** erfolgt in der in Fig. 2 gezeigten Ausführungsform mittels einer Leitung **14,** insbesondere einer Rohrleitung, die mit einem Hohlraum **15** verbunden ist, wobei der Hohlraum 15 mit der ersten Kältestufe **18a** des Kaltkopfs 4a kontaktiert ist. Die Leitung 14 wird durch ein Aufhängerohr **29c** des weiteren Kryobehälters 3 geführt und mündet in den weiteren Kryobehälter 3. Aus dem weiteren Kryobehälter 3 wird verdampftes Kryogen, z.B. Stickstoff, durch die Leitung 14 in den Hohlraum 15 geleitet, wo das Kryogen durch Wärmeaustausch mit dem Kaltkopf 4a verflüssigt und anschließend durch die Leitung 14 wieder in den weiteren Kryobehälter 3 zurückgeleitet wird. Die Leitung 14 kann auch als konzentrische Leitung, bestehend aus zwei Rohren, ausgeführt sein: Im äußeren Rohrspalt steigt dann der Kryogendampf zum Hohlraum 15 auf, während das verflüssigte Kryogen im Innenrohr in den weiteren Kryobehälter 3 zurückfließt. Des Weiteren ist es von Vorteil, die Leitung zumindest teilweise oder auch über ihre gesamte Länge mit einer Vakuumisolierung zu versehen.

Der Kaltkopf 4a dient darüber hinaus auch der Kühlung eines HF-Resonators **16** und eines Vorverstärkers **17** des NMR-Probenkopfs 1. Der NMR-Probenkopf 1 ist dabei nicht direkt mit dem Kaltkopf 4a verbunden, sondern über einen Kälteträger, der in einem geschlossenen Kreislauf fließt, mit diesem in Kontakt. Die Transferleitung 7 (bestehend aus vier einzelnen Leitungssträngen) verbindet den NMR-Probenkopf 1 mit der ersten Kältestufe 18a und der zweiten Kältestufe **19a** des Kaltkopfs 4a, wobei sich die erste Kältestufe 18a des Kaltkopfs 4a auf etwa 65 K und die zweite Kältestufe 19a auf etwa 12 K befindet. Beide Kältestufen 18a, 19a weisen zur Kälteentnahme thermische Kontaktflächen auf, an die beispielsweise Wärmetauscher angeschlossen werden können, durch die ein Wärmeübertrag vom Kälteträger des Kühlkreislaufs zum Kaltkopf 4a erfolgen kann.

Der Kälteträger (z.B. Helium) wird im Kühlkreislauf des NMR-Probenkopfs 1 mittels des Kompressors 5 des Kryokühlers umgewälzt. Der Kälteträger wird zuerst mit Hilfe eines ersten Gegenstromtauschers **21** und dann an der ersten Kältestufe 18a des Kaltkopfs 4a auf 65 K vorgekühlt, bevor er zum zweiten Gegenstromtauscher **22** und schließlich zur zweiten Kältestufe 19a gelangt. Dort wird der Kälteträger auf 12 K hinunter gekühlt. Der so abgekühlte Kälteträger wird über die Transferleitung 7 dem HF-Resonator 16 zugeführt, wodurch letzterer auf etwa 15 K abgekühlt wird. Anschließend gelangt der auf 15 K aufgewärmte Kälteträger wieder über die Transferleitung 7 in das Gehäuse 6 und zum zweiten Gegenstromtauscher 22. Nach Durchlaufen des zweiten Gegenstromtauschers 22 wird ein Teil des Kälteträgers über die Transferleitung 7 dem Vorverstärker 17 zugeführt, wodurch dieser auf etwa 77 K abgekühlt wird. Anschließend gelangt der auf 77 K aufgewärmte Kälteträger wieder über die Transferleitung 7 in das Gehäuse 6, wo er mit dem Restteilstrom aus dem zweiten Gegenstromtauscher 22 vermischt und über den ersten Gegenstromtauscher 21 zum Kompressor 5 geführt wird.

Die Kühlung des ersten Kryobehälters 2, des weiteren Kryobehälters 3 und des NMR-Probenkopfs1 erfolgt also mittels eines einzigen Kaltkopfs 4a mittels drei separater Mechanismen zur Kälteübertragung. Das Gehäuse 6 mit dem Kaltkopf 4a ist mit dem Kryostaten 9 und dem NMR-Probenkopf 1 gasdicht über Balgen 10 verbunden, so dass vom Kaltkopf 4a ausgehende Schwingungen nicht auf den Kryostaten 9 und den NMR-Probenkopf 1 übertragen, zumindest aber stark abgedämpft werden.

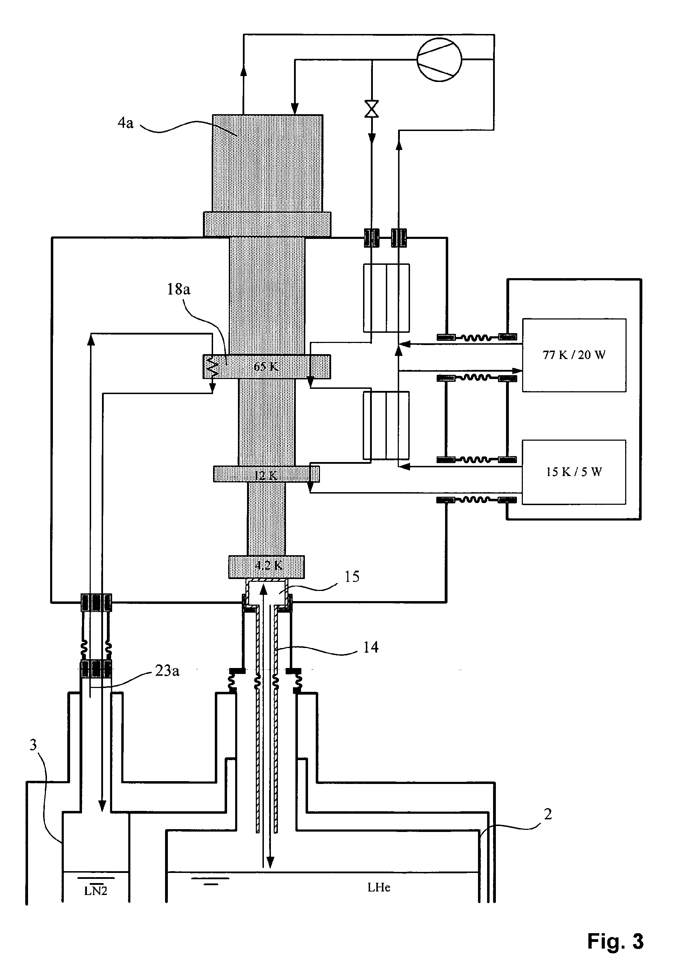

**Fig. 3** zeigt eine Ausführungsform der Erfindung, bei welcher der erste Kryobehälter 2 mittels einer mit einem Hohlraum 15 verbundenen Leitung 14 gekühlt wird. Im weiteren Kryobehälter 3 ist eine weitere Leitung **23a** eingeführt, die zur ersten Kältestufe 18a des Kaltkopfs 4a führt und mit dieser kontaktiert ist. Verdampftes und auf etwa Umgebungstemperatur erwärmtes Kryogen wird durch die weitere Leitung 23a zur ersten Kältestufe 18a des Kaltkopfes 4a geleitet. An der ersten Kältestufe 18a findet ein Wärmeübergang vom Kryogen zur Kältestufe 18a statt, wodurch das Kryogen abgekühlt und verflüssigt und zurück in den weiteren Kryobehälter 3 geleitet wird.

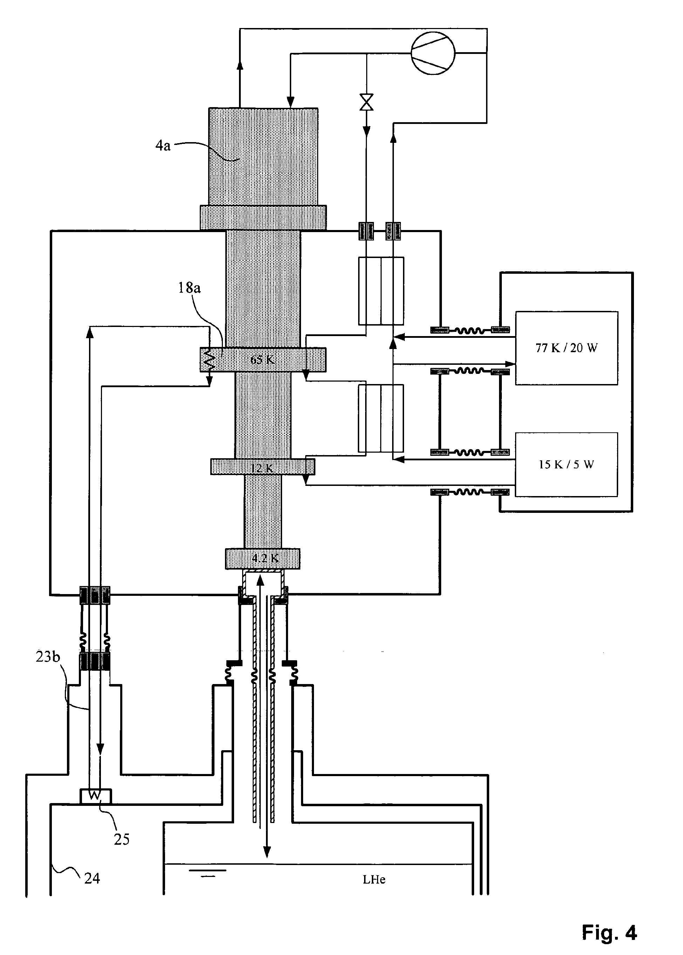

In der in **Fig. 4** dargestellten Ausführungsform der Erfindung wird statt eines weiteren Kryobehälters 3 ein Strahlungsschild **24** gekühlt. Eine weitere Leitung **23b** bildet hier einen geschlossenen Kreislauf, in dem ein Kälteträger an der ersten Kältestufe 18a des Kaltkopfes 4a abgekühlt und zu einem Wärmetauscher **25** geleitet wird. Der Wärmetauscher 25 ist mit dem Strahlungsschild 24 kontaktiert und nimmt somit Wärme von dem Strahlungsschild 24 auf. Der Kühlkreislauf der weiteren Leitung 23b wird hierbei über Eigenkonvektion angetrieben. Denkbar ist jedoch auch der Einsatz einer Umwälzpumpe.

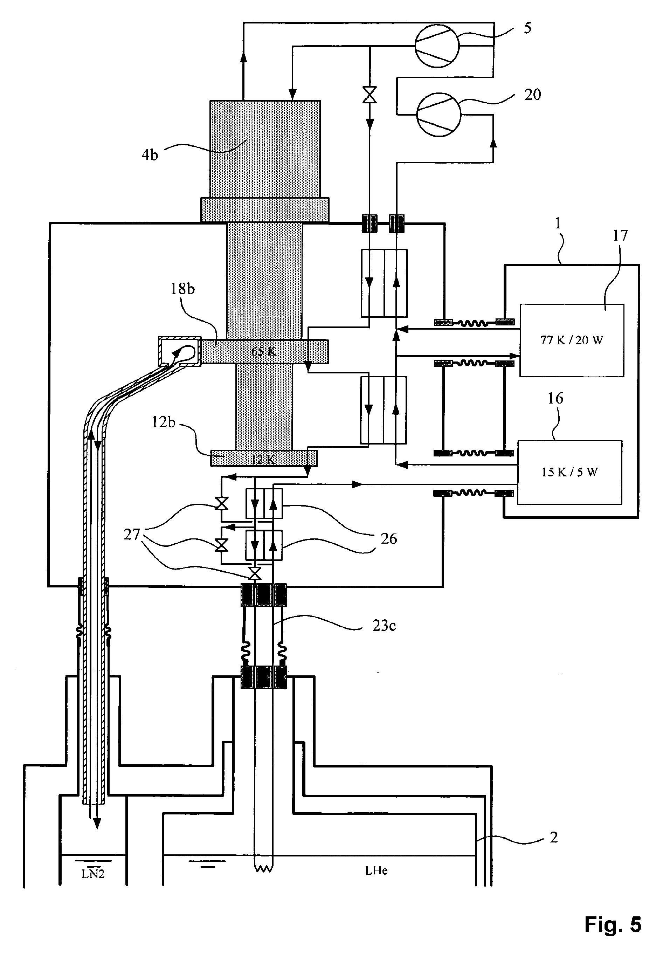

Bei der NMR-Apparatur aus **Fig. 5** ist die Kühlung des ersten Kryobehälters 2 direkt mit der Kühlung des NMR-Probenkopfs 1 kombiniert und in einem einzigen Kühlkreislauf verwirklicht. Zur Kühlung ist hier im Gegensatz zu den Beispielen aus Fig. 2 bis 4 ein zweistufiger Kaltkopf **4b** mit Kältestufen **18b, 12b** vorgesehen, wobei die kälteste Kältestufe 12b eine Temperatur von etwa 12 K aufweist. Der Kälteträger (Helium) des geschlossenen Kreislaufs wird an den Kältestufen 18b, 12b des Kaltkopfs 4b gekühlt und den zu kühlenden Komponenten (erster Kryobehälter 2, HF-Resonator 16, Vorverstärker 17) zugeführt. Zusätzlich zu dem in Fig. 2 beschriebenen Kühlkreislauf des NMR-Probenkopfs 1 wird bei der in Fig. 5 gezeigten NMR-Apparatur der Kälteträger des Kühlkreislaufs von der kältesten Kältestufe 12b des Kaltkopfs 4b nach Abkühlung in zwei Gegenstromtauschern **26** in den ersten Kryobehälter 2 geleitet, in dem eine weitere Leitung **23c** in Kontakt mit dem im ersten Kryobehälter 2 befindlichen Kryogen kommt. Nach Abkühlung des Kälteträgers an der Kältestufe 12b auf etwa 12 K wird der Strom des Kälteträgers geteilt, so dass ein Teil durch weitere Gegenstromtauscher 26 fließt und ein anderer Teil in Vorrichtungen **27** zum Zwischenentspannen, z.B. Joule Thomson-Ventilen, abgekühlt wird. Eine Abkühlung bei isenthalper Druckabsenkung tritt dann auf, wenn der verwendete Kälteträger beim vorgegebenen Anfangs- und Endzustand einen positiven integralen Joule-Thomson-Koeffizienten aufweist. Die somit abgekühlten Teilströme dienen der Vorkühlung des dem ersten Kryobehälter 2 zugeführten Teilstroms in den Gegenstromtauschern 26. Durch eine letzte Entspannung auf einen Druck etwas unterhalb des im ersten Kryobehälter vorhandenen Drucks wird der vorgekühlte Teilstrom schließlich teilweise verflüssigt. Nach Aufnahme von Wärme aus dem ersten Kryobehälter 2 fließt der jetzt wieder als Sattdampf oder leicht überhitzter Dampf vorliegende Kälteträger durch die weiteren Gegenstromtauscher 26 zurück, erwärmt sich dabei und wird in den NMR-Probenkopf 1 geleitet, um dort den HF-Resonator 16 und den Vorverstärker 17 zu kühlen. Da der Kälteträger in den Joule-Thomson-Ventilen auf einen tiefen Druck, in der Regel Umgebungsdruck oder leicht darunter, entspannt werden muss, ist ein weiterer (kleinerer) Kompressor **20** notwendig, um den Kälteträger wieder auf das Niederdruckniveau des Kältekompressors 5 zu verdichten. Es ist jedoch auch denkbar, dass der Kühlkreislauf komplett getrennt wird vom Kältekompressor 5 und somit zusätzlich ein separater Kompressor eingesetzt wird, der den Kälteträger von Umgebungsdruck auf einen zur Prozessführung notwendigen Hochdruck verdichtet.

Die Kombination der Kühlung des ersten Kryobehälters 2 mit der Kühlung des NMR-Probenkopfs 1 hat jedoch den Nachteil, dass eine unabhängige Kühlung beider Teilsysteme ohne weiteres nicht mehr möglich ist. Will man zum Beispiel die Probenkopfkühlung unterbrechen, die Kühlung des Kryobehälters 2 aber beibehalten, so müssen weitere Armaturen und Leitungen im Kühlkreislauf vorgesehen werden, wodurch der apparative Aufwand steigt.

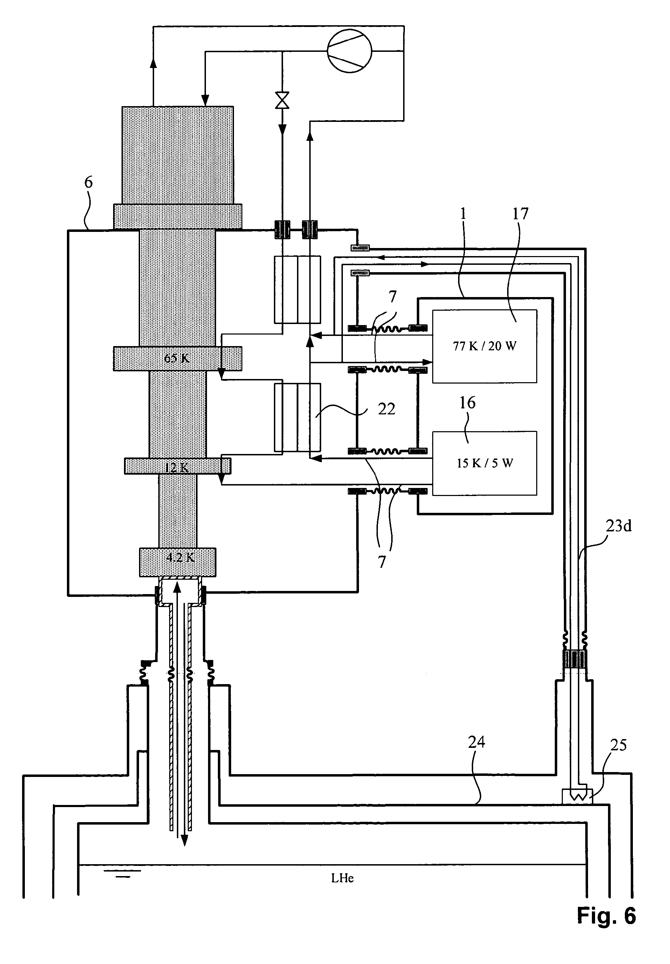

Bei der in **Fig. 6** gezeigten Vorrichtung sind die Kühlkreisläufe des NMR-Probenkopfs 1 und des Strahlungsschildes 24 zu einem geschlossenen Kühlkreislauf gekoppelt. Da sowohl der Vorverstärker 17 als auch der Strahlungsschild 24 auf etwa 77K gekühlt werden sollen, wird ein Teil des für die Probenkopfkühlung verwendeten Kälteträgers nach Durchlaufen des HF-Resonators 16 und des zweiten Gegenstromtauschers 22 vom Hauptstrom abgezweigt und in der weiteren Leitung 23d zum Strahlungsschild 24 geführt, während der andere Teil des Kälteträgers den Vorverstärker 17 durchläuft. Der dem Strahlungsschild 24 zugeführte Kälteträger nimmt dann über den Wärmetauscher 25 die auf den Strahlungsschild 24 einfallende Wärme auf, und wird innerhalb des Gehäuses 6 mit dem Rücklauf aus dem Vorverstärker 17 vereint. Bei der in Fig. 6 gezeigten Ausführungsform ist eine unabhängige Kühlung von Strahlungsschild 24 und NMR-Probenkopf 1 nicht mehr möglich.

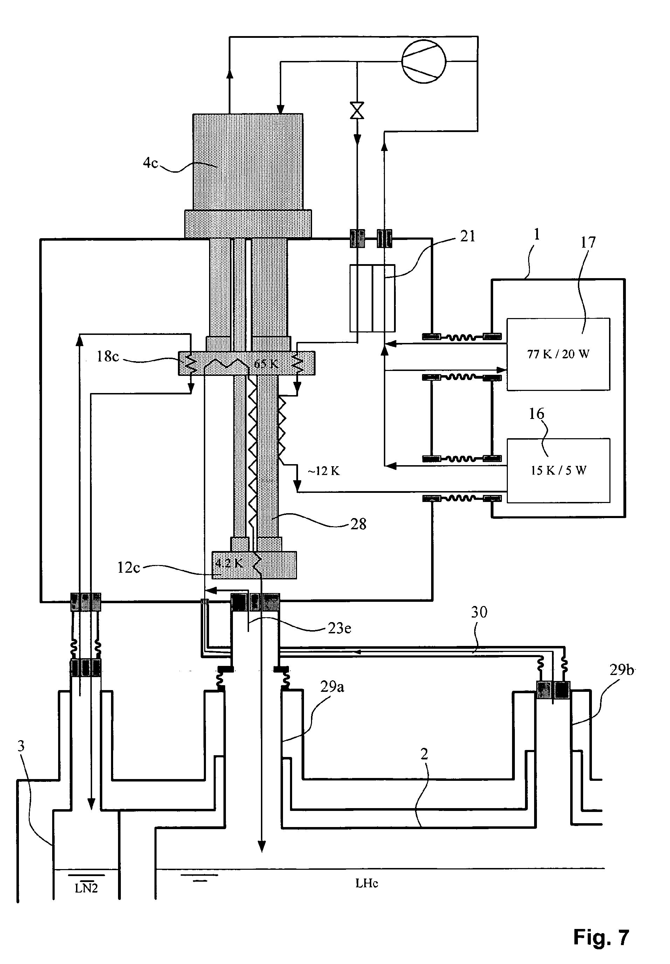

Besonders vorteilhaft ist es, wenn ein Kaltkopf **4c** eines Pulsrohrkühlers mit zwei Kältestufen **18c, 12c** verwendet wird. Der Kälteträger des Kreislaufs zur Kühlung des Probenkopfs 1 und das im ersten Kryobehälter 2 verdampfte und erwärmte Kryogen können dann in Wärmekontakt mit dem Regeneratorrohr **28** der kältesten Kältestufe12c des Pulsrohrkühlers gebracht werden. Dies ist in **Fig. 7** gezeigt. Das durch Wärmeeinfall verdampfte und in den Aufhängerohren **29a** und **29b** erwärmte Kryogen wird durch Leitungen **23e, 30** in das Gehäuse 6 geführt, dort vereinigt und zur ersten Kältestufe 18c des Kaltkopfs 4c geleitet, wo es auf etwa 65 K heruntergekühlt wird. Anschließend wird das Kryogen entlang des Regeneratorrohrs 28 weiter abgekühlt, schließlich in Kontakt mit der kältesten Kältestufe 12c des Kaltkopfs 4c verflüssigt und in den ersten Kryobehälter 2 zurückgeführt. Auf diese Weise werden die Aufhängerohre 29a und 29b gekühlt und der Wärmeeintrag auf den ersten Kryobehälter 2 reduziert.

Da der HF-Resonator 16 lediglich auf ca. 15 K gekühlt werden muss, ist es nicht notwendig, den für die Kühlung des HF-Resonators 16 verwendeten Kälteträger auf die Temperatur der kältesten Kältestufe 12c (4,2 K) abzukühlen. Daher sieht die in Fig. 7 dargestellte Ausführungsform vor, dass der Kälteträger des Kühlkreislaufs des NMR-Probenkopfs 1 im Gegenstromtauscher 21 mit dem abströmenden Kälteträger aus dem NMR-Probenkopf 1 und anschließend an der ersten Kältestufe 18c des Kaltkopfs 4c vorgekühlt und schließlich entlang eines Abschnitts des Regeneratorrohrs 28 der kältesten Kältestufe 12c bis zu der benötigten Temperatur abgekühlt wird. Der Kälteträger des Kühlkreislaufs des NMR-Probenkopfs 1 wird also nicht bis zum kalten Ende der kältesten Kältestufe 12c des Kaltkopfs 4c geführt, sondern lediglich bis zu einer Stelle des Regeneratorrohrs 28, an der der Kälteträger die Temperatur aufweist, welche für die Kühlung des HF-Resonators 16 und des Vorverstärkers 17 des NMR-Probenkopfs 1 geeignet ist. Durch die frei wählbare Länge der Kontaktfläche des Kälteträgers mit dem Regeneratorrohr 28 ist es möglich, die Kühltemperatur des Kälteträgers in einem Temperaturbereich zwischen der Temperatur der kältesten Kältestufe 12c (4,2 K) und der ersten Kältestufe 18c (z.B. 65 K) auf die gewünschte Anwendung zu optimieren. Der zusätzliche Wärmeeintrag auf das Regeneratorrohr 28 der kältesten Kältestufe 12c beeinträchtigt die Kälteleistung der kältesten Kältestufe 12c des Pulsrohrkühlers. Bei geeigneter Prozessführung und Ausführung kann die thermodynamische Effizienz des Gesamtsystems auf diese Weise allerdings sogar gesteigert werden. Ferner kann die Anzahl der Gegenstromtauscher verringert werden.

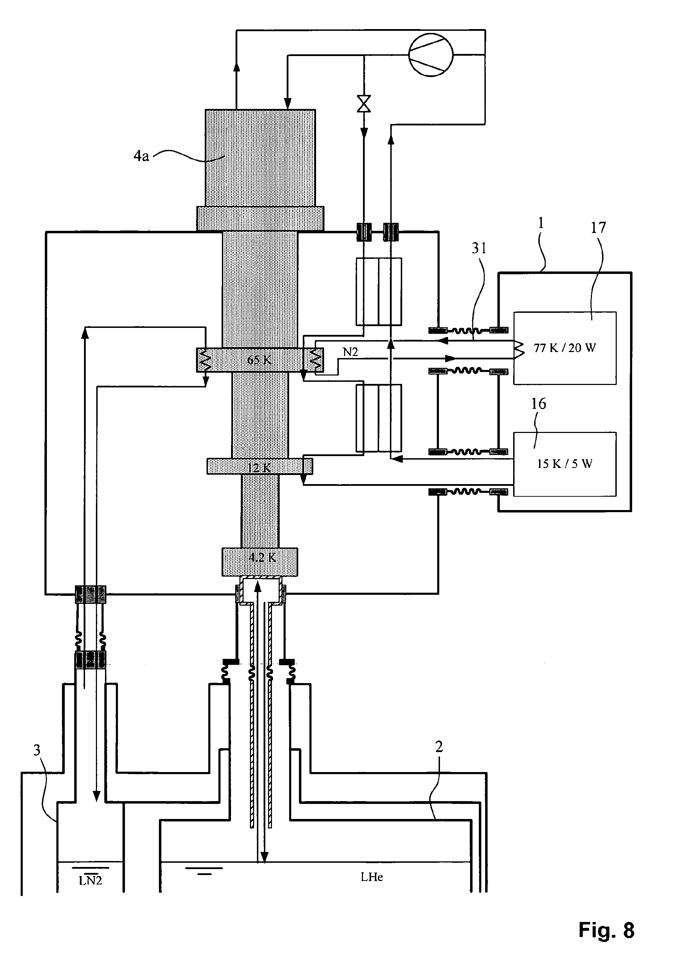

Als Kälteträger für die geschlossenen Kühlkreisläufe wird vorzugsweise überkritisches Helium verwendet. Für die Kühlung des Vorverstärkers 17 des NMR-Probenkopfs 1 kann jedoch auch ein separater geschlossener Kühlkreislauf **31** vorgesehen sein, wie in **Fig. 8** gezeigt. Dieser Kühlkreislauf 31 kann mit einem höher siedenden Kälteträger (z.B. Stickstoff) betrieben werden, da der Vorverstärker 17 nur auf etwa 77K abgekühlt werden muss. Die in Fig. 8 gezeigte Ausführungsform der erfindungsgemäßen NMR-Apparatur realisiert die Kühlung der Kryobehälter 2, 3 sowie des Vorverstärkers 17 und des HF-Resonators 16 mittels eines einzigen Kaltkopfs 4a und vier separater Mechanismen zur Kälteankopplung. Auf diese Weise ist es beispielsweise möglich, den NMR-Probenkopf 1 aufzuwärmen ohne den Kryokühler (und somit die Magnetkühlung) abzustellen.

Insgesamt ergibt sich eine NMR-Apparatur mit einer effizienten Kühlung und verbesserten Vibrationsentkopplung, wobei gleichzeitig der Verlust an Kryogen minimiert wird. Auch weist die erfindungsgemäße Vorrichtung eine reduzierte Beeinflussung des Magnetfeldes des Magnetsystems durch die magnetischen Regeneratormaterialien des Kaltkopfs (und umgekehrt) auf. Darüber hinaus wird es ermöglicht, selbst bei einem Unterbruch der Kühlung des Kryostaten NMR-Messungen weiterzuführen, da die vorhanden kryogenen Flüssigkeiten die Kühlung des Magneten zumindest vorübergehend aufrechterhalten.

### Bezugszeichenliste

- 1: NMR-Probenkopf
- 2: erster Kryobehälter
- 3: weiterer Kryobehälter
- 4: Kaltkopf
- 4a: 3-stufiger Kaltkopf
- 4b: 2-stufiger Kaltkopf
- 4c: 2-stufiger Kaltkopf eines Pulsrohrkühlers
- 5: Kältekompressor
- 6: evakuiertes Gehäuse
- 7: Transferleitung
- 8: Ständer
- 9: Kryostat
- 10: Balg
- 11: gut leitende Verbindung
- 12a: kälteste Kältestufe des 3-stufigen Kaltkopfs
- 12b: kälteste Kältestufe des 2-stufigen Kaltkopfs
- 12c: kälteste Kältestufe des 2-stufigen Kaltkopfs des Pulsrohrkühlers
- 13: Litzen
- 14: Leitung
- 15: Hohlraum
- 16: HF-Resonator
- 17: Vorverstärker
- 18a: erste Kältestufe des 3-stufigen Kaltkopfs
- 18b: erste Kältestufe des 2-stufigen Kaltkopfs
- 18c: erste Kältestufe des 2-stufigen Kaltkopfs des Pulsrohrkühlers
- 19a: zweite Kältestufe des 3-stufigen Kaltkopfs
- 20: weiterer Kompressor
- 21: erster Gegenstromtauscher
- 22: zweiter Gegenstromtauscher
- 23a: weitere Leitung des Kühlkreislaufs des weiteren Kryobehälters
- 23b: weitere Leitung des Kühlkreislaufs des Strahlungsschildes
- 23c: weitere Leitung des Kühlkreislaufs des Pulsrohrkühlers
- 23d: weitere Leitung des Kühlkreislaufs des Strahlungsschildes
- 23e: weitere Leitung des Kühlkreislaufs des ersten Kryobehälters
- 24: Strahlungsschild
- 25: Wärmetauscher
- 26: weitere Gegenstromtauscher
- 27: Vorrichtung zum Zwischenentspannen
- 28: Regeneratorrohr der kältesten Kältestufe
- 29a: Aufhängerohr des ersten Kryobehälters
- 29b: Weiteres Aufhängerohr des ersten Kryobehälters
- 29c: Aufhängerohr des weiteren Kryobehälters
- 30: Verbindungsleitung
- 31: Kühlkreislauf für Vorverstärker

## Patentansprüche

1. NMR-Apparatur mit einem in einem ersten Kryobehälter (2) eines Kryostaten (9) angeordneten NMR-Magnetsystem und mit einem in einer Raumtemperaturbohrung des Kryostaten (9) angeordneten NMR-Probenkopf (1), der einen HF-Resonator (16) zum Empfang von NMR-Signalen aus einer zu untersuchenden Probe und einen Vorverstärker (17) umfasst,
wobei der erste Kryobehälter (2) in einem evakuierten Außenmantel eingebaut ist und von mindestens einem Strahlungsschild (24) und/oder einem weiteren Kryobehälter (3) umgeben ist,
wobei zur Kühlung des NMR-Probenkopfs (1) und mindestens eines Kryobehälters (2, 3) eine Kühlvorrichtung vorgesehen ist, welche einen kompressorbetriebenen Kaltkopf (4, 4a, 4b, 4c) eines Kryokühlers mit mehreren Kältestufen (12a, 12b, 12c, 18a, 18b, 18c, 19a) auf unterschiedlichen Temperaturniveaus umfasst,
wobei mindestens eine Kältestufe (12a, 12b, 12c, 18a, 18b, 18c, 19a) des Kaltkopfes (4, 4a, 4b, 4c) mit einer Wärme übertragenden Vorrichtung thermisch leitend verbunden ist, und
wobei mindestens ein über eine zumindest teilweise wärmeisolierte Transferleitung (7) durch den-Kompressor (5) des Kryokühlers oder eine Pumpe angetriebener Kühlkreislauf mit einem Kälteträger zwischen der Kühlvorrichtung und dem NMR-Probenkopf (1) vorgesehen ist,
**dadurch gekennzeichnet,**
**dass** die Kühlvorrichtung in einem separaten, evakuierten und wärmeisolierten Gehäuse (6) angeordnet ist, welches unmittelbar oberhalb des Kryostaten (9) des NMR-Magnetsystems positioniert ist,
wobei mindestens eine der Wärme übertragenden Vorrichtungen direkt und unmittelbar in Aufhängerohre (29a, 29c) des ersten und/oder weiteren Kryobehälters (2, 3) des Kryostaten (9), durch welche die Kryobehälter (2, 3) mit dem Außenmantel verbunden sind, eingeführt und/oder mit dem Strahlungsschild (24) kontaktiert ist.

2. NMR-Apparatur nach Anspruch 1, **dadurch gekennzeichnet, dass** die Kühlvorrichtung über Bauteile, welche Schwingungen stark dämpfen oder nicht übertragen, insbesondere über Balgen (10), mit dem Kryostaten (9) des NMR-Magnetsystems und dem Probenkopf (1) gasdicht verbunden ist.

3. NMR-Apparatur nach Anspruch 1 oder 2, **dadurch gekennzeichnet, dass** zumindest eine der Wärme übertragenden Vorrichtungen eine metallische Verbindung (11) mit hoher Wärmeleitfähigkeit aufweist, an deren Ende, welches in das Aufhängerohr (29a, 29c) des Kryobehälters (2, 3) hineinragt, ein Kryogen, das aus einem der Kryobehälter (2, 3) des Kryostaten (9) verdampft, verflüssigt wird.

4. NMR-Apparatur nach einem der vorhergehenden Ansprüche, **dadurch gekennzeichnet, dass** der Kryokühler ein Pulsrohrkühler oder ein Gifford-McMahon-Kühler mit mindestens zwei Kältestufen (12a, 12b, 12c, 18a, 18b, 18c, 19a) ist.

5. NMR-Apparatur nach einem der vorhergehenden Ansprüche, **dadurch gekennzeichnet, dass** zur Hinführung des aus einem der Kryobehälter (2, 3) des Kryostaten (9) verdampften Kryogens zu der Kältestufe (12a, 12b, 12c, 18a, 18b, 18c, 19a), und zur Rückführung des an der Kältestufe (12a, 12b, 12c, 18a, 18b, 18c, 19a) verflüssigten Kryogens in den Kryobehälter (2, 3) des Kryostaten (9), zumindest eine der Wärme übertragenden Vorrichtungen eine an beiden Enden offene Leitung (14), insbesondere eine Rohrleitung, und einen Hohlraum (15) aufweist, wobei das eine offene Ende der Leitung in den Hohlraum (15) und das andere offene Ende der Leitung in den Kryobehälter (2, 3) mündet.

6. NMR-Apparatur nach einem der vorhergehenden Ansprüche, **dadurch gekennzeichnet, dass** zur Hinführung des aus dem weiteren Kryobehälter (3) des Kryostaten (9) verdampften und im Aufhängerohr (29c) auf etwa Umgebungstemperatur erwärmten Kryogens zu der Kältestufe (18a, 19a), welche nicht die kälteste Kältestufe ist, und zur Rückführung des an der Kältestufe (18a, 19a) auf Verflüssigungstemperatur abgekühlten und verflüssigten Kryogens in den weiteren Kryobehälter (3), zumindest eine der Wärme übertragenden Vorrichtungen eine weitere, an beiden Enden offene Leitung (23a), insbesondere eine Rohrleitung, mit guter thermischer Kontaktierung an der Kältestufe (18a, 19a) aufweist, die an einem offenen Ende mit dem warmen Ende des Aufhängerohres (29c) verbunden ist und deren anderes offene Ende bis in den weiteren Kryobehälter (3) reicht.

7. NMR-Apparatur nach einem der Ansprüche 4 bis 6, **dadurch gekennzeichnet, dass** zur Hinführung des aus dem ersten Kryobehälter (2) des Kryostaten (9) verdampften und im Aufhängerohr (29a) auf etwa Umgebungstemperatur erwärmten Kryogens zu der oder den Kältestufen (18c) des Kaltkopfs (4c) des Pulsrohrkühlers, welche wärmer als die kälteste Kältestufe (12c) sind, und zur Rückführung des Kryogens in den ersten Kryobehälter (2) die Wärme übertragende Vorrichtung eine weitere, an beiden Enden offene Leitung (23e) aufweist, insbesondere eine Rohrleitung, mit guter thermischer Kontaktierung an der oder den Kältestufen (18c, 12c) des Kaltkopfs (4c) des Pulsrohrkühlers und an zumindest dem kältesten Regeneratorrohr (28) der Kältestufen (12c, 18c) des Kaltkopfs (4c) des Pulsrohrkühlers, wobei die weitere Leitung (23e) an einem der offenen Enden mit dem warmen Ende des Aufhängerohres (29a) verbunden ist und das andere offene Ende der weiteren Leitung (23e) bis in den ersten Kryobehälter (2) reicht, so dass das Kryogen auf Verflüssigungstemperatur abgekühlt und verflüssigt wird.

8. NMR-Apparatur nach einem der vorhergehenden Ansprüche, **dadurch gekennzeichnet, dass** eine der Wärme übertragenden Vorrichtungen, die in den ersten Kryobehälter (2) eingeführt ist, als Teilkreislauf des Kühlkreislaufs des NMR-Probenkopfs (1) ausgeführt ist, wobei als Kälteträger ein tiefsiedendes Gas vorgesehen ist, und dass eine Vorrichtung (27) zum Zwischenentspannen eines Teils des Kälteträgers vorgesehen ist, um einen anderen Teil des Kälteträgers vorzukühlen, wobei der Kühlkreislauf über den Kompressor (5) des Kryokühlers und/oder einen weiteren Kompressor (20) angetrieben wird.

9. NMR-Apparatur nach einem der vorhergehenden Ansprüche, **dadurch gekennzeichnet, dass** die die Wärme übertragende Vorrichtung zumindest abschnittsweise flexibel, insbesondere als Balg (10) und/ oder in Form von zu Litzen (13) verflochtenen Drähten, ausgeführt ist.

10. NMR-Apparatur nach einem der vorhergehenden Ansprüche, **dadurch gekennzeichnet, dass** an der kältesten Kältestufe (12a, 12b, 12c) des Kaltkopfs (4, 4a, 4b, 4c) des Kryokühlers flüssiges Helium bei einer Temperatur von 4,2 K oder bei tieferer Temperatur erzeugt werden kann, und dass an einer Kältestufe (18a, 18b, 18c, 19a) des Kaltkopfs (4, 4a, 4b, 4c) des Kryokühlers flüssiger Stickstoff bei einer Temperatur von 77 K oder bei tieferer Temperatur erzeugt werden kann.

11. NMR-Apparatur nach einem der Ansprüche 4 bis 10, **dadurch gekennzeichnet, dass** im Kühlkreislauf zur Kühlung des NMR-Probenkopfs (1) sich zumindest ein Teil des Kälteträgers in Wärmekontakt mit zumindest dem kältesten Regeneratorrohr (28) der Kältestufen (12c, 18c) des Pulsrohrkühlers befindet, so dass der Kälteträger auf eine Temperatur im Bereich zwischen den Temperaturen der beiden kältesten Kältestufen (12c, 18c) abgekühlt wird.

12. NMR-Apparatur nach einem der vorhergehenden Ansprüche, **dadurch gekennzeichnet, dass** in mindestens einem der Kryobehälter und/oder an den Kältestufen (12a, 12b, 12c, 18a, 18b, 18c, 19a) des Kaltkopfes (4, 4a, 4b, 4c) des Kryokühlers der Kühlvorrichtung oder an anderen Bestandteilen der Kühlvorrichtung, insbesondere an den Wärme übertragenden Vorrichtungen oder an den Leitungen (14, 23a, 23b, 23c, 23d, 23e), eine elektrische Heizung vorgesehen ist.

13. Verfahren zum Betrieb einer NMR-Apparatur nach einem der vorhergehenden Ansprüche, wobei der NMR-Probenkopf (1) sowie mindestens ein Kryobehälter (2, 3) der NMR-Apparatur mittels eines gemeinsamen Kryokühlers gekühlt werden,
**dadurch gekennzeichnet,**
**dass** die zur Kühlung des NMR-Probenkopfs (1) und des Kryobehälters (2, 3) benötigte Temperatur und Kälteleistung außerhalb des Kryostaten (9) erzeugt werden,
wobei mindestens eine mit dem Kaltkopf (4, 4a, 4b, 4c) des Kryokühlers kontaktierte Wärme übertragende Vorrichtung direkt und unmittelbar in Aufhängerohre (29a, 29c) des ersten und/oder weiteren Kryobehälters (2, 3) des Kryostaten (9) eingeführt und/oder mit dem Strahlungsschild (24) kontaktiert wird,
wobei mit Hilfe der Wärme übertragenden Vorrichtung eine Verflüssigung des im Kryobehälter (2, 3) vorhandenen gasförmigen Kryogens stattfindet, und
wobei über mindestens eine zumindest teilweise wärmeisolierte Transferleitung (7) außerhalb des Kryostaten (9) ein Kälteträger von der Kühlvorrichtung zu dem NMR-Probenkopf (1) geleitet wird.

14. Verfahren nach Anspruch 13, **dadurch gekennzeichnet, dass** die Verflüssigung des im Kryobehälter (2, 3) vorhandenen gasförmigen Kryogens am Ende einer in zumindest einen der Kryobehälter (2, 3) hineinragenden metallischen, die Wärme sehr gut leitenden Verbindung (11) erfolgt.

15. Verfahren nach Anspruch 13, **dadurch gekennzeichnet, dass** aus einem der Kryobehälter (2, 3) des Kryostaten (9) verdampftes Kryogen durch eine Leitung(14), insbesondere eine Rohrleitung, in einen Hohlraum (15) an der Kältestufe (12a, 12b, 12c, 18a, 18b, 18c, 19a) des Kaltkopfs (4, 4a, 4b, 4c) des Kryokühlers geleitet, an der Kältestufe (12a, 12b, 12c, 18a, 18b, 18c, 19a) verflüssigt, und anschließend durch die Rohrleitung (14) in den Kryobehälter (2, 3) des Kryostaten (9) zurückgeleitet wird.

16. Verfahren nach Anspruch 13, **dadurch gekennzeichnet, dass** das aus einem der Kryobehälter (2, 3) des Kryostaten (9) verdampfte Kryogen im Aufhängerohr (29a, 29b, 29c) des Kryobehälters (2, 3) auf etwa Umgebungstemperatur erwärmt wird, durch eine weitere Leitung (23a, 23e) und/oder die Verbindungsleitung (30), insbesondere eine Rohrleitung, mit guter thermischer Kontaktierung an der Kältestufe (12a, 12b, 12c, 18a, 18b, 18c, 19a), zu der Kältestufe (12a, 12b, 12c, 18a, 18b, 18c, 19a) hingeführt, dort und gegebenenfalls zumindest an dem kältesten Regeneratorrohr (28) der Kältestufen (12c, 18c) des Kaltkopfs (4c) des Pulsrohrkühlers abgekühlt und schließlich verflüssigt wird, und als verflüssigtes Kryogen durch die weitere Leitung (23a, 23e) in den Kryobehälter (2, 3) rückgeführt wird.

17. Verfahren nach Anspruch 13, **dadurch gekennzeichnet, dass** die Wärmeübertragung zwischen mindestens einer Kältestufe (12a, 12b, 12c, 18a, 18b, 18c, 19a) des Kaltkopfs (4, 4a, 4b, 4c) und mindestens einem der Kryobehälter (2, 3) und/oder dem Strahlungsschild (24) innerhalb eines Teilkreislauf des Kühlkreislaufs des NMR-Probenkopfs (1) erfolgt, wobei der Kreislauf über den Kompressor (5) des Kryokühlers oder gegebenenfalls eine Umwälzpumpe angetrieben wird.

18. Verfahren nach Anspruch 17, **dadurch gekennzeichnet, dass** zur Kühlung des ersten Kryobehälters (2) ein Teil des Kälteträgers durch Zwischenentspannung eines anderen Teils des Kälteträgers so vorgekühlt wird, dass durch Entspannung des vorgekühlten Teils des Kälteträgers auf den gleichen oder einen tieferen Gasdruck wie im ersten Kryobehälter der Kälteträger verflüssigt wird.

19. Verfahren nach Anspruch 13, **dadurch gekennzeichnet, dass** als Kryokühler ein Pulsrohrkühler verwendet wird und der zum Kühlen des NMR-Probenkopfs (1) vorgesehene Kälteträger in Wärmekontakt mit zumindest dem kältesten Regeneratorrohr (28) der Kältestufen (12c, 18c) des Kaltkopfes (4c) des Pulsrohrkühlers gebracht und somit auf eine Temperatur im Bereich zwischen den Temperaturen der beiden kältesten Kältestufen (12c, 18c) abgekühlt wird.
